# EUROPEAN PATENT SPECIFICATION

(11) **EP 1 271 782 B1**
(45) Date of publication and mention of the grant of the patent: **18.05.2005**
(21) Application number: 02012610.8
(22) Date of filing: 06.06.2002
(51) Int. Cl.: H03K 19/177

(54) **FPGA with at least two different and independently configurable memory structures**
FPGA mit zumindest zwei unterschiedlichen und unabhängig konfigurierbaren Speicherstrukturen
FPGA avec au moins deux structures de mémoire différentes et configurables indépendamment

(30) Priority: 29.06.2001 IN DE07282001
(43) Date of publication of application: 02.01.2003
(73) Proprietor: STMicroelectronics Pvt. Ltd, Noida-201 301, Uttar Pradesh (IN)
(72) Inventor: Singh, Moninder, New Delhi, 110 027 India (IN); Chaudhry, Anurag, New Delhi, 110064 India (IN)
(74) Representative: Bosotti, Luciano

(56) References cited:
- EP-A- 1 239 592
- EP-A- 5 801 547
- WO-A-98/10517
- US-A- 6 049 223
- US-A- 6 104 208
- US-A- 6 144 220
- US-B1- 6 191 998
- BURSKY D.: 'Efficient RAM-Based FPGAs Ease System Design' ELECTRONIC DESIGN 22 January 1996, pages 53 - 62, XP0000580106

## Description

### BACKGROUND OF THE INVENTION

### 1. Field of the invention:

The present invention relates to a field programmable logic device with efficient memory utilization.

### 2. Description of the prior art:

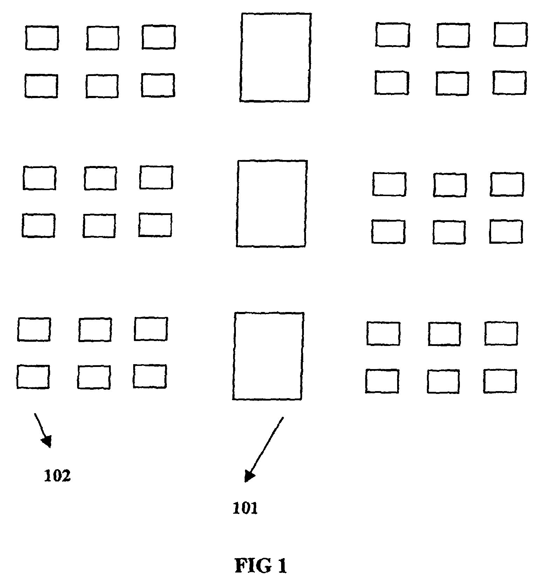

Configurable memories are embedded in field programmable logic devices to provide on-chip fast RAM. There are two types of memory resources commercially available as shown in **FIG 1.** The first type are the LUTs inside Logic blocks **102 of FIG1,** that can be combined in various fashions to provide memories of varying widths and depths as in Xilinx XC4000 and Virtex devices. The Xilinx device, along with some improvements, is discussed e.g. in D.BURSKY: "Efficient RAM-Based FPGAs Ease System Design" ELECTRONIC DESIGN, 22 January 1996 (1996-01-22), pages 53-62, XP0000580106,after which the preambles of claims 1 and 12 were patterned.

A drawback with these distributed memory resources is that the large memory formed by combining these resources is slow. Moreover one has to provide read/write control circuitry with all LUTs. In case these LUTs are not used to implement memory then the read/write control circuitry associated with LUTs is wasted.

The second type of on-chip memory resources is the large chunks/blocks of RAM bits **101 of FIG1,** as provided by Xilinx and Altera. These can be configured to provide memories with varying widths and depths. A drawback associated with these resources is that if a block (of say 4k) is used to implement a small memory (say 512x2)), then there is wastage of unused RAM bits (3K). Moreover if a logical memory supports an odd width (say 256x9) then there is even more wastage of resources.

The following scenario provides the motivation for providing heterogeneous memory structures in an FPGA or PLD.

US patent no. 5801547 described embedded memory structures of the same type, which may be combined and configured independently. Accordingly, this patent also suffers from the drawbacks described above, the same also applying to other documents of interest represented by WO 98/10517A, US-B-6191998, US-A-6104208, US-A-6049223, US-A-6144220, and US-A-5933023.

### SUMMARY OF THE INVENTION

The object of this invention is to obviate the above drawbacks.

To achieve the said objective this invention provides a field programmable logic device having the features set forth in claim 1.

The said memory structures provide mutually exclusive configuration options in at least one configuration parameter

The said memory structures are combined to form larger configurations through interconnection of dedicated memory routing tracks and horizontal routing channels

The said dedicated memory routing tracks comprising plurality of bus based vertical tracks originating from memory IOs.

The horizontal routing channels comprising several routing tracks.

The said dedicated memory routing track interact with the horizontal routing channels through programmable switches.

A single set of dedicated memory routing track spans one or more memory block and a plurality of horizontal routing channels

The upper and lower end of dedicated memory routing tracks are a set of bus based bi-directional programmable buffers to connect different blocks of memory to form deeper and / or wider memories.

Since each memory structure supports only a subset of total configuration modes available, the size of the multiplexer at the input/ output of said memories will be reduced thereby enhancing the speed of access to the memories.

The said memory structures are used independently or in combination to implement logic functions.

The said memory structures are multi-port.

The said memory structures are Read Only Memory (ROM), Random Access Memory (RAM), Content Addressable Memory (CAM), First In First Out (FIFO) structures.
The invention also relates to a method for making a corresponding device.

### BRIEF DESCRIPTION OF THE DRAWINGS

The objects and advantages of the invention will become more apparent in reference to the following description and the accompanying drawings, wherein:
Figure 1 shows the memory structure according to the prior art consisting of only one type of embedded memory array
Figure 2 shows the arrangement according to present invention wherever two types of embedded memory arrays are provided
Figure 3 shows the example of the use of two different configurable memory structures to obtain memory of different width.
Figure 4 shows the implementation for obtaining 256 x 9 logical memory
Figure 5 shows the preferred method of memory to memory and memory to logic interaction.

### DETAILED DESCRIPTION

It is proposed to provide two or more types of memory resources with the types being distinguishable by the configuration modes supported by them or their size or both.

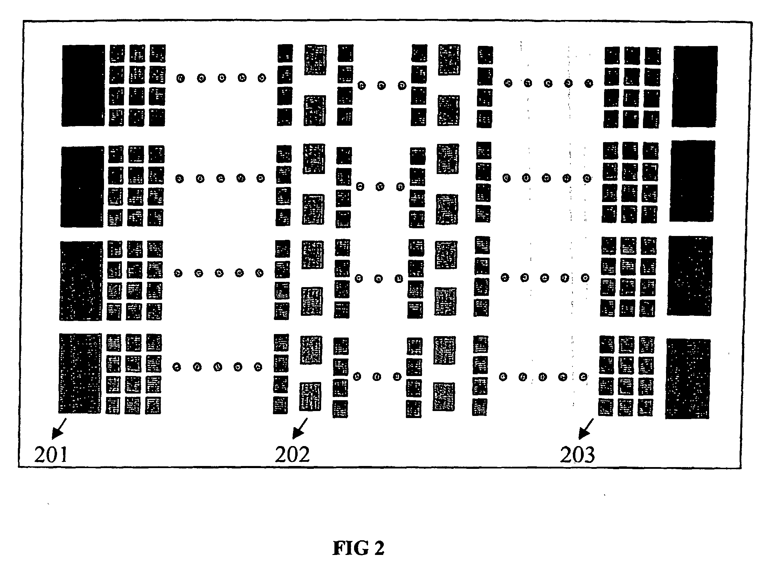

For ease of understanding, at present consider only two types of memory resources. In one embodiment, the different memory structures can be distinguished both on the basis of the configuration modes supported by them and their sizes as shown in **Fig 2. FIG2** represents the preferred type of Programmable Logic device that includes three types of programmable resources viz. **201, 202, 203.** Component **201** represents programmable memory block with wider configurable data widths and/or larger core size with respect to component **202.** Component **202** represents programmable memory block with smaller configurable data widths and/or smaller core size with respect to component **201.** Component **203** represents programmable logic blocks that can be any of a PLA or LUT based circuit to implement logic intensive circuits.

**202 of FIG2** supports small memory requirements (memory size) with plurality of smaller configurable word sizes for example x1, x2, and x4. The smaller configurable memory arrays can be combined using dedicated (bus-based) as well as general routing resources to create wider or deeper memories. **201 of FIG2** supports large memory requirements (memory size) with plurality of larger configurable word sizes as x8, x16, and x32. The larger memory arrays can also be combined using separate dedicated (bus-based) as well as general routing resources to create wider or deeper memories.

Since each memory structure is supporting only a subset of the total configuration modes available, the size of the multiplexer at the input/output of the memories will be reduced. Reduced flexibility at each level enhances the speed of operation at both levels, though it does not affect the overall number of possible combinations of different word sizes available. As the configuration modes supported by both types of memory structures are mutually exclusive they do interact with each other and no separate routing resources between the two types of memory structures are needed.

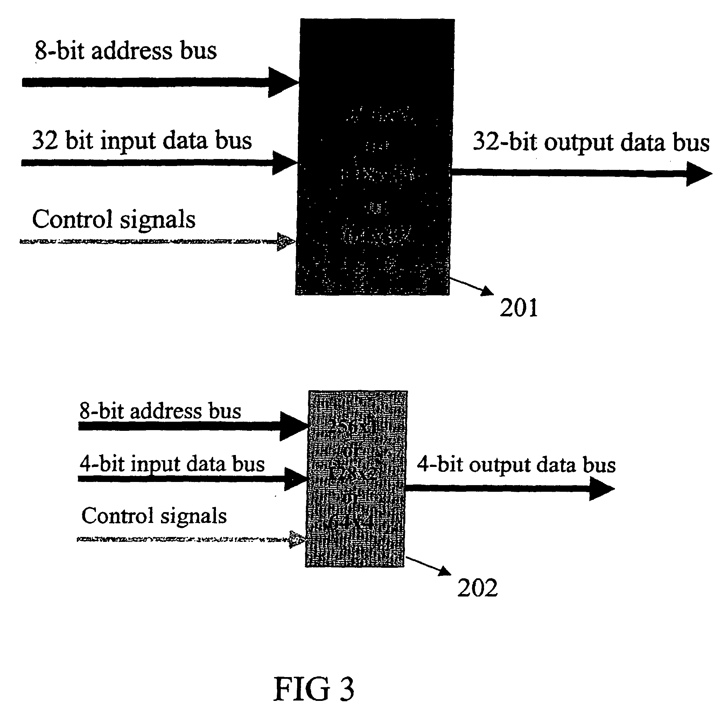

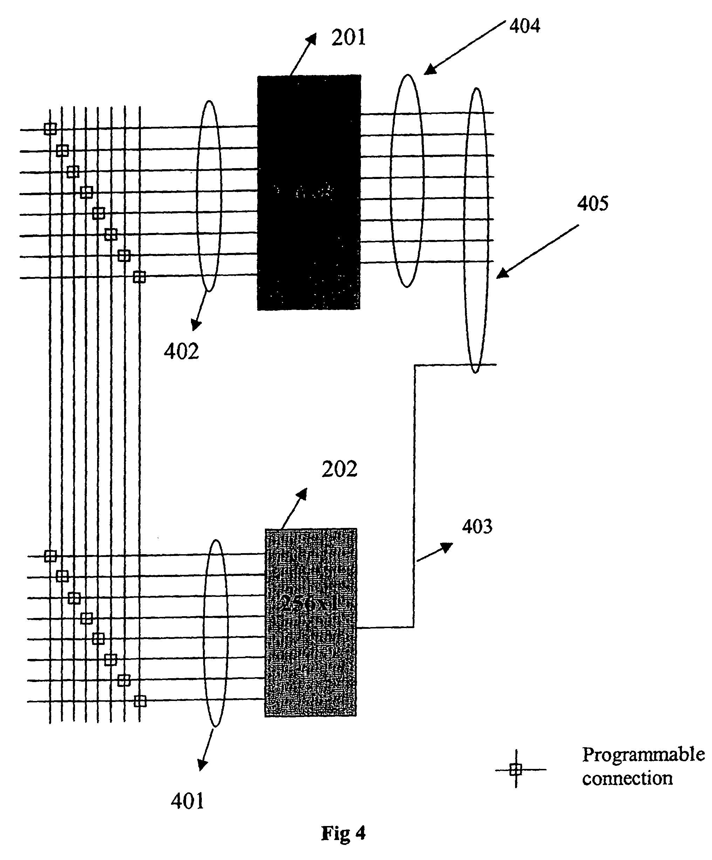

As shown in **FIG3**, consider if the size of the smaller memory structure is 256 bits and that of the larger memory structure is 2Kbits implying that the smaller memory can implement any of 256x1, 128x2 or 64x4 and the larger can implement any of the 256x8, 128x16 or 64x32 then x9, x18, x36 modes can also be easily realized as the memory depth in both the memory structures is the same. One of these types of implementation is illustrated in **FIG4**.

**FIG4** shows one of the preferred ways to implement a 256x9 logical memory that may be required in some designs. In **FIG4,** one block of **201** memory and one block of **202** memories are combined to form a memory block of size 256x9. The block of **202** memory is configured in 256x1 mode. 256x1 mode means that this memory has 256 words of 1 bit each. To address 256 words, this memory requires 8 address lines **401,** and its output data bus **403,** is 1 bit wide. The block of **201** memory is configured in 256x8 mode. 256x8 mode means that this memory has 256 words of 8 bit each. To address 256 words, this memory requires 8 address lines **402,** and its output data bus **404,** is 8 bits wide. Now to create a 256x9 memory block, the **201** and **202** blocks are combined in the following manner. The address buses of **202** block and **201** block, i.e., **401** and **402** are shorted. The short connection is provided through routing segments and programmable connections (see **FIG4**). The output data buses of both the blocks together, i.e., **403** and **404** represent the data bus, **405** of 256x9 memory.

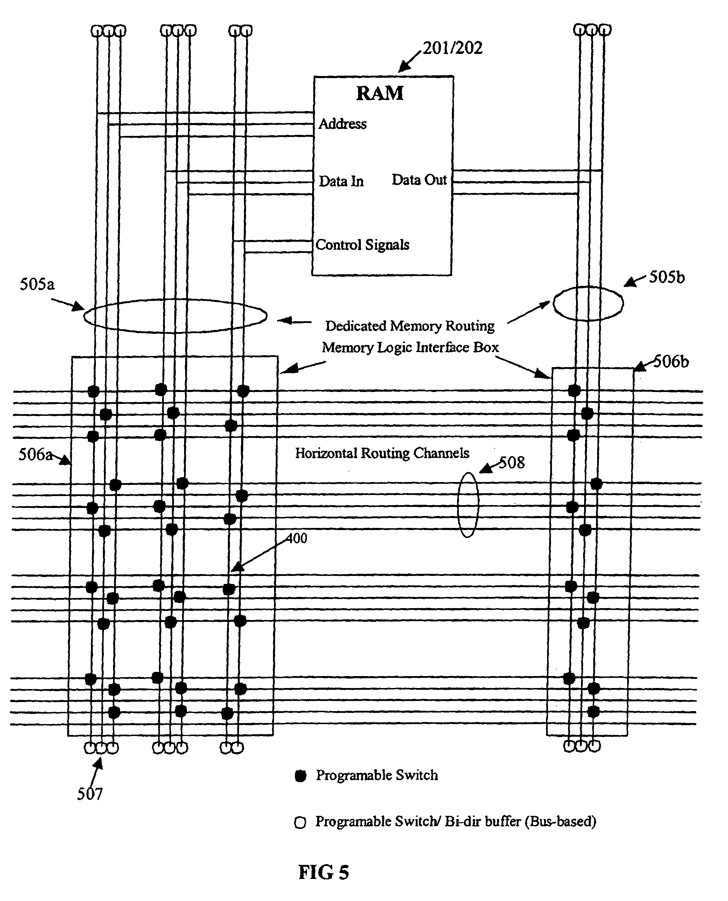

**FIG5** shows a preferred way of memory to memory and memory to logic interaction scheme. The memory block (any of **202** or **201)** interacts with logic blocks **203,** and other memory blocks through dedicated memory routing tracks and horizontal routing channels. The dedicated memory routing tracks (**505a** & **505b**) consist of plurality of bus-based vertical tracks (originating from memory I/Os) that interact with horizontal routing channels **508,** through programmable switches, **400.** The horizontal routing tracks in turn interact with logic blocks. The horizontal routing channels also consist of several routing tracks. The dedicated memory routing tracks interact with horizontal routing channels through programmable switches.

A single set of dedicated memory routing tracks spans one (or more) memory block and a plurality of horizontal routing channels (as shown in the **FIG5**). At the upper and the lower ends of dedicated memory routing tracks are a set of bus-based bi-directional programmable buffers **507**, that help to connect different blocks of memories to form deeper and/or wider memories.

The connection box where dedicated memory routing tracks interact with horizontal routing channels is called Memory Logic Interface (**506a & 506b**). The interconnections between memory blocks and logic blocks are made possible with this Memory Logic Interface box. It is to be noted that the attached figure is only a representation of the case. In actual connections the number of address and data lines would be larger than shown in the figure.

Also the number of tracks in horizontal channel, and the topology of switches in Memory Logic Interface box could be different.

In another embodiment of the invention, the different memory structures are distinguished on the basis of the configuration modes supported by them but have same size.

In another embodiment different memory structures are provided that are distinguished on the basis of their sizes but supporting same configuration modes.

Also, in another embodiment both or any one of the memories can be used in asynchronous ROM mode to implement substantial logic when the design does not require all the on-chip memory resources provided thus saving LUTs in all the cases considered above.
The above explanation can be easily extended to more than two types of memory resources.

## Claims

1. A field programmable logic device comprising at least two independently configurable embedded memory structures (201, 202) said at least two memory structures including:
- a first memory structure (201) with first configuration options of configurable configuration parameters including a first memory size, a first set of available configuration depths, and a first set of available configuration widths,
- a second memory structure (202) with second configuration options of configurable configuration parameters including a second memory size, a second set of available configuration depths, and a second set of available configuration widths,
said memory structures (201, 202) being interconnected (505a, 505b, 508) to form a combined memory structure having a combined set of configuration parameters, **characterized in that**
said first and second configuration options are independently configurable and mutually exclusive in respect of at least one of said configurable parameters, said combined set of configuration parameters including at least one combined parameter comprised of the combination of mutually exclusive homologous parameters of said first (201) and second (202) memory structure for efficient memory utilization without redundancy.

2. A field programmable logic device as claimed in claim 1, wherein said memory structures are combined to form larger configurations through interconnection of dedicated memory routing tracks (505a, 505b) and horizontal routing channels (508).

3. A field programmable logic device as claimed in claim 2, wherein said dedicated memory routing tracks (505a, 505b) comprising plurality of bus based vertical tracks originating from memory IOs.

4. A field programmable logic device as claimed in claim 2, wherein horizontal routing channels (508) comprising several routing tracks.

5. A field programmable logic device as claimed in claim 2, wherein said dedicated memory routing tracks (505a, 505b) interact with the horizontal routing channels (508) through programmable switches (400).

6. A field programmable logic device as claimed in claim 2, wherein a single set of dedicated memory routing tracks (505a, 505b) spans one or more memory blocks and a plurality of horizontal routing channels (508).

7. A field programmable logic device as claimed in claim 2, wherein the upper and lower end of dedicated memory routing tracks (505a, 505b) are a set of bus based bi-directional programmable buffers (507) to connect different blocks of memory to form deeper and/or wider memories.

8. A field programmable logic device as claimed in claim 1, wherein since each memory structure (201, 202) supports only a subset of total configuration modes available, the size of the multiplexer at the input/output of said memories (201, 202) will be reduced thereby enhancing the speed of access to the memories.

9. A field programmable logic device as claimed in claim 1, wherein said memory structures (201, 202) are used independently or in combination to implement logic functions.

10. A field programmable logic device as claimed in claim 1, wherein said memory structures (201, 202) are multi-port.

11. A field programmable logic device as claimed in claim 1, wherein said memory structures (201, 202) are Read Only Memory (ROM), Random Access Memory (RAM), Content Addressable Memory (CAM), First In First Out (FIFO) structures.

12. A method of making a field programmable logic device comprising at least two independently configurable embedded memory structures (201, 202) the method including the steps of:
- providing a first memory structure (201) with first configuration options of configurable configuration parameters including a first memory size, a first set of available configuration depths, and a first set of available configuration widths,
- providing a second memory structure (202) with second configuration options of configurable configuration parameters including a second memory size, a second set of available configuration depths, and a second set of available configuration widths,
- interconnecting (505a, 505b, 508) said memory structures (201, 202) to form a combined memory structure having a combined set of configuration parameters, **characterized in that** the method further includes the steps of:
- making said first and second configuration options independently configurable and mutually exclusive in respect of at least one of said configurable parameters, and
- including in said combined set of configuration parameters at least one combined parameter comprised of the combination of mutually exclusive homologous parameters of said first (201) and second (202) memory structure for efficient memory utilization without redundancy.

## Patentansprüche

1. Eine vom Anwender programmierbare logische Vorrichtung, welche mindestens zwei unabhängig voneinander konfigurierbare eingebettete Speicherstrukturen (201, 202) umfaßt, wobei die mindestens zwei Speicherstrukturen beinhalten:
- eine erste Speicherstruktur (201) mit ersten Konfigurationsoptionen konfigurierbarer Konfigurationsparameter, welche eine erste Speichergröße, einen ersten Satz verfügbarer Konfigurationstiefen und einen ersten Satz verfügbarer Konfigurationsbreiten beinhalten,
- eine zweite Speicherstruktur (202) mit zweiten Konfigurationsoptionen konfigurierbarer Konfigurationsparameter, welche eine zweite Speichergröße, einen zweiten Satz verfügbarer Konfigurationstiefen und einen zweiten Satz verfügbarer Konfigurationsbreiten beinhalten,
wobei die Speicherstrukturen (201, 202) miteinander verbunden sind (505a, 505b, 508), um eine kombinierte Speicherstruktur mit einem kombinierten Satz von Konfigurationsparametern auszubilden, **dadurch gekennzeichnet, daß**
die ersten und zweiten Konfigurationsoptionen unabhängig konfigurierbar und sich gegenseitig ausschließend bezüglich mindestens eines der konfigurierbaren Parameter sind, wobei der kombinierte Satz von Konfigurationsparametern mindestens einen kombinierten Parameter umfaßt, welcher aus der Kombination sich gegenseitig ausschließender homologer Parameter der ersten (201) und zweiten (202) Speicherstruktur zur wirksamen Speicheranwendung ohne Redundanz zusammengesetzt ist.

2. Eine vom Anwender programmierbare logische Vorrichtung nach Anspruch 1, wobei die Speicherstrukturen kombiniert sind, um größere Konfigurationen durch die Verbindung zugeordneter Speicherleitspuren (505a, 505b) und horizontaler Leitkanäle (508) auszubilden.

3. Eine vom Anwender programmierbare logische Vorrichtung nach Anspruch 2, wobei die zugeordneten Speicherleitspuren (505a, 505b) eine Vielzahl von busbasierten vertikalen Spuren umfassen, die von Speicher-Ein/Ausgabe-Systemen ausgehen.

4. Eine vom Anwender programmierbare logische Vorrichtung nach Anspruch 2, wobei die horizontalen Leitkanäle (508) mehrere Leitspuren umfassen.

5. Eine vom Anwender programmbierbare logische Vorrichtung nach Anspruch 2, wobei die zugeordneten Speicherleitspuren (505a, 505b) mit den horizontalen Leitkanälen (508) über programmierbare Schaltungen (400) zusammenwirken.

6. Eine vom Anwender programmierbare logische Vorrichtung nach Anspruch 2, wobei ein einzelner Satz zugeordneter Speicherleitspuren (505a, 505b) sich über einen oder mehrere Speicherblöcke und eine Vielzahl horizontaler Leitkanäle (508) erstreckt.

7. Eine vom Anwender programmierbare logische Vorrichtung nach Anspruch 2, wobei die oberen und unteren Enden der zugeordneten Speicherleitspuren (505a, 505b) einen Satz busbasierter bidirektionaler Pufferspeicher (507) sind, um verschiedene Speicherblöcke zu verbinden, um tiefere und/oder breitere Speicher auszubilden.

8. Eine vom Anwender programmierbare logische Vorrichtung nach Anspruch 1, wobei die Größe des Multiplexkanals an der Eingabe/Ausgabe des Speichers (201, 202) verringert wird, wenn jede Speicherstruktur (202, 202) nur einen Untersatz der verfügbaren Gesamtkonfigurationmodi unterstützt, wodurch die Zugriffsgeschwindigkeit auf die Speicher gesteigert wird.

9. Eine vom Anwender programmierbare logische Vorrichtung nach Anspruch 1, wobei die Speicherstrukturen (201, 202) unabhängig voneinander oder in Kombination verwendet werden, um logische Funktionen zu implementieren.

10. Eine vom Anwender programmierbare logische Vorrichtung nach Anspruch 1, wobei die Speicherstrukturen (201, 202) Mehrtore sind.

11. Eine vom Anwender programmierbare logische Vorrichtung nach Anspruch 1, wobei die Speicherstrukturen (201, 202) Festspeicher (ROM), Direktzugriffsspeicher (RAM), Assoziativspeicher (CAM), First-In/First-Out-Strukturen (FIFO) sind.

12. Ein Verfahren zur Herstellung einer vom Anwender programmierbaren logischen Vorrichtung, welche mindestens zwei unabhängig voneinander konfigurierbare eingebettete Speicherstrukturen (201, 202) umfaßt, wobei das Verfahren die Schritte beinhaltet:
- Versehen einer ersten Speicherstruktur (201) mit ersten Konfigurationsoptionen konfigurierbarer Konfigurationsparameter, die eine erste Speichergröße, einen ersten Satz verfügbarer Konfigurationstiefen und einen ersten Satz verfügbarer Konfigurationsbreiten beinhaltet,
- Versehen einer zweiten Speicherstruktur (202) mit zweiten Konfigurationsoptionen konfigurierbarer Konfigurationsparameter, die eine zweite Speichergröße, einen zweiten Satz verfügbarer Konfigurationstiefen und einen zweiten Satz verfügbarer Konfigurationsbreiten beinhaltet,
- Verbinden (505a, 505b, 508) der Speicherstrukturen (201, 202), um eine kombinierte Speicherstruktur auszubilden, welche einen kombinierten Satz Konfigurationsparameter aufweist, **dadurch gekennzeichnet, daß** das Verfahren ferner die Schritte beinhaltet:
- daß erste und zweite Konfigurationsoptionen hinsichtlich mindestens eines der konfigurierbaren Parameter unabhängig voneinander konfiguierbar und sich gegenseitig ausschließend gemacht werden, und
- daß in diesen kombinierten Satz von Konfigurationsparametern mindestens ein kombinierter Parameter eingefügt wird, welcher aus der Kombination sich gegenseitig ausschließender homologer Parameter der ersten (201) und zweiten (202) Speicherstruktur zur wirksamen Speicheranwendung ohne Redundanz zusammengesetzt ist.

## Revendications

1. Un dispositif logique programmable sur site, comprenant au moins deux structures de mémoire (201, 202) intégrées, configurables indépendamment, lesdites au moins deux structures de mémoire comprenant :
- une première structure de mémoire (201) ayant des premières options de configuration concernant des paramètres de configuration configurables, incluant une première taille de mémoire, un premier jeu de profondeurs de configuration disponibles, et un premier jeu de largeurs de configuration disponibles,
- une deuxième structure de mémoire (202). ayant des deuxièmes options de configuration concernant des paramètres de configuration configurables, incluant une deuxième taille de mémoire, un deuxième jeu de profondeurs de configuration disponibles, et un deuxième jeu de largeurs de configuration disponibles,
- lesdites structures de mémoire (201, 202) étant interconnectées (505a, 505b, 508) pour former une structure de mémoire combinée ayant un jeu combiné de paramètres de configuration, **caractérisé en ce que**
lesdites premières et deuxièmes options de configuration sont configurables indépendamment et mutuellement exclusives par rapport à au moins l'un desdits paramètres configurables, ledit jeu combiné de paramètres de configuration incluant au moins un paramètre combiné, composé de la combinaison de paramètres homologues mutuellement exclusifs de ladite première (201) et deuxième (202) structures de mémoire pour fournir une utilisation efficace de la mémoire sans redondance.

2. Un dispositif logique programmable sur site selon la revendication 1, dans lequel lesdites structures de mémoire sont combinées pour former des configurations plus grandes par interconnexion de chemins d'acheminement de mémoire dédiés (505a, 505b) et de canaux d'acheminement horizontaux (508).

3. Un dispositif logique programmable sur site selon la revendication 2, dans lequel lesdits chemins d'acheminement de mémoire dédiés (505a, 505b) comprennent une pluralité de chemins verticaux à base de bus, provenant des entrées/sortie à la mémoire.

4. Un dispositif logique programmable sur site selon la revendication 2, dans lequel des canaux d'acheminement horizontaux (508) comprennent une pluralité de chemins d'acheminement.

5. Un dispositif logique programmable sur site selon la revendication 2, dans lequel lesdits chemins d'acheminement de mémoire dédiés (505a, 505b) interagissent avec les canaux d'acheminement horizontaux (508), par des interrupteurs programmables (400).

6. Un dispositif logique programmable sur site selon la revendication 2, dans lequel un jeu unique de chemins d'acheminement de mémoire (505a, 505b) dédiés couvre un ou plusieurs blocs de mémoire et une pluralité de canaux d'acheminement horizontaux (508).

7. Un dispositif logique programmable sur site selon la revendication 2, dans lequel l'extrémité supérieure et inférieure des chemins d'acheminement de mémoire dédiés (505a, 505b) sont un jeu de tampons programmables bidirectionnels (507) à base de bus, pour connecter différents blocs de mémoire afin de former des mémoires plus profondes et/ou plus larges.

8. Un dispositif logique programmable sur site selon la revendication 1, dans lequel, étant donné que chaque structure de mémoire (201, 202) supporte uniquement un sous-jeu des modes de configuration totale disponibles, la taille du multiplexeur à l'entrée/sortie desdites mémoires (201, 202) va être réduite, améliorant de cette manière la vitesse d'accès aux mémoires.

9. Un dispositif logique programmable sur site selon la revendication 1, dans lequel lesdites structures de mémoire (201, 202) sont utilisées indépendamment ou en combinaison pour mettre en oeuvre des fonctions logiques.

10. Un dispositif logique programmable sur site selon la revendication 1, dans lequel lesdites structures de mémoire (201, 202) sont de type multi-port.

11. Un dispositif logique programmable sur site selon la revendication 1, dans lequel lesdites structures de mémoire (201, 202) sont une Mémoire à Lecture Seule (ROM), une Mémoire à Accès Aléatoire (RAM), une Mémoire à Contenu Adressable (CAM), et des structures Premier Entré Premier Sorti (FIFO).

12. Un procédé de réalisation d'un dispositif logique programmable sur site, comprenant au moins deux structures mémoire intégrées (201, 202) configurables indépendamment, le procédé comprenant les étapes consistant à :
- fournir à une première structure de mémoire (201) des premières options de configuration de paramètres de configuration configurables, incluant une première taille mémoire, un premier jeu de profondeurs de configuration disponibles, et un premier jeu de largeurs de configuration disponibles,
- fournir à une deuxième structure de mémoire (202) des deuxièmes options de configuration de paramètres de configuration configurables, incluant une deuxième taille mémoire, un deuxième jeu de profondeurs de configuration disponibles, et un deuxième jeu de largeurs de configuration disponibles,
- interconnecter (505a, 505b, 508) lesdites structures de mémoire (201, 202) pour former une structure de mémoire combinée, ayant un jeu combiné de paramètres de configuration, **caractérisé en ce que** le procédé comprend en outre les étapes consistant à :
- rendre lesdites premières et deuxièmes options de configuration configurables indépendamment et mutuellement exclusives eu égard à au moins l'un desdits paramètres configurables, et
- inclure dans ledit jeu combiné des paramètres de configuration, au moins un paramètre combiné composé de la combinaison de paramètres homologues mutuellement exclusifs de ladite première (201) et deuxième (202) structures de mémoire, pour une utilisation efficace de la mémoire, sans redondance.
